Europäisches Patentamt

European Patent Office

Office européen des brevets

(11) Veröffentlichungsnummer: **0 206 057**
**B1**

(12) EUROPÄISCHE PATENTSCHRIFT

(45) Veröffentlichungstag der Patentschrift: 02.05.90

(21) Anmeldenummer: 86107746.9

(22) Anmeldetag: 06.06.86

(51) Int. Cl.⁵: **G 01 R 33/34, G 01 N 24/08**

(54) **Probenkopf für Kernresonanz(NMR)-Messungen, insbesondere für die NMR-Tomographie.**

(30) Priorität: 22.06.85 DE 3522401

(43) Veröffentlichungstag der Anmeldung:
30.12.86 Patentblatt 86/52

(45) Bekanntmachung des Hinweises auf die
Patenterteilung:
02.05.90 Patentblatt 90/18

(84) Benannte Vertragsstaaten:
DE FR GB NL

(56) Entgegenhaltungen:
EP-A-0 047 065
EP-A-0 084 946
EP-A-0 141 383
DE-A-3 133 432

(73) Patentinhaber: Bruker Medizintechnik GmbH
Silberstreifen
D-7512 Rheinstetten-Forchheim (DE)

(72) Erfinder: Biehl, Reinhard, Dr.
Reinhold-Schneider-Strasse 123
D-7500 Karlsruhe 51 (DE)
Erfinder: Laukien, Günther, Prof. Dr.
Silberstreifen 8
D-7512 Rheinstetten 4 (DE)

(74) Vertreter: Patentanwälte Kohler - Schwindling -
Späth
Hohentwielstrasse 41
D-7000 Stuttgart 1 (DE)

**Beschreibung**

Die Erfindung betrifft einen Probenkopf für Kernresonanz-Messungen gemäß dem Oberbegriff des Anspruches 1.

Ein derartiger Probenkopf ist aus der EP-A-0 084 946 bekannt.

Bei dem bekannten Probenkopf besteht der äußere zylindrische Mantel aus Metallblech und ist durchgehend mit den ebenfalls aus Metallblech bestehenden Stirnflächen verbunden. Der innere zylindrische Mantel wird von einem Kunststoffrohr gebildet, das an seinen, den Stirnflächen benachbarten Enden jeweils einen raumfesten, rohrförmig umlaufenden und elektrisch leitenden Abschnitt aufweist. Im Inneren des in dieser Weise allseitig gekapselten Zwischenraumes zwischen den Mänteln befindet sich eine torusförmige, kurzgeschlossene Spule. Die Spule ist aus Koaxialkabel gewickelt, dessen Außenmantel im Bereich der jeweils inneren, an dem Kunststoffrohr anliegenden Windung über eine Länge entfernt ist, die im Abstand zwischen den leitfähigen Streifen auf dem Kunststoffrohr entspricht, wodurch gleichmäßig über den Umfang des Kunststoffrohres als rohrförmiger Tragkörper verteilte, zueinander parallele und axial verlaufende elektrische Leiter gebildet sind. An einem dieser Leiter ist zur Speisung der Leiter aus einer gemeinsamen Hochfrequenz-Stromquelle eine Koppelanordnung in Gestalt eines parallel geführten Koaxialkabels befestigt, das an seinem einen Ende zu einem Steckkontakt in einer Stirnfläche führt und dessen Innenleiter am anderen Ende mit der gegenüberliegenden Stirnfläche verbunden ist. Eine Ankopplung der Hochfrequenz-Energie kann auch über elektrische Felder erfolgen. Auch kann jeder Leiter an eine separate Hochfrequenz-Energiequelle angekoppelt sein.

Bei dem bekannten Probenkopf soll erreicht werden, daß die Komponenten des elektrischen bzw. magnetischen Feldes der kurzgeschlossenen torusförmigen Spule mit Ausnahme des Bereiches des freiliegenden Innenleiters vollkommen abgeschirmt sind. Nur im Bereich dieses freiliegenden Innenleiters soll durch das Kunststoffrohr hindurch in dem vom inneren zylindrischen Mantel umgrenzten Probenraum ein hochfrequentes Magnetfeld erzeugt werden, das über den gesamten Probenraum senkrecht zur Längsachse des Probenkopfes ausgerichtet und sehr homogen ist. Dabei ist der Probenkopf so dimensioniert und die Koppelanordnung so ausgelegt, daß sich bei gegebener Frequenz des Hochfrequenz-Speisestromes eine stehende Welle im Probenkopf ausbildet.

Der bekannte Probenkopf hat jedoch den Nachteil, daß er sehr kompliziert im Aufbau ist und vor allem erhebliche Justageprobleme auftreten, weil die einzelnen, voneinander beabstandeten Windungen der torusförmigen Spule hochgenau positioniert sein müssen, was in der Praxis zu erheblichen Problemen führen dürfte, weil die einzelnen Windungen lediglich mit ihrem Außenmantel an die elektrisch leitenden Streifen bzw. die umgebenden Stirnflächen und den äußeren zylindrischen Mantel angelötet sind. Diese praktischen Schwierigkeiten begrenzen auch die Zahl der möglichen Windungen auf beispielsweise 24 Windungen, so daß auch der erzielbaren Homogenität des Hochfrequenzfeldes hierdurch eine Grenze gesetzt ist.

Bei diesem bekannten Probenkopf ist ferner die Abschirmung in Gestalt eines äußeren zylindrischen, elektrisch leitfähigen Mantels und zweier daran angrenzender Stirn flächen im wesentlichen dazu vorgesehen, um das aus der torusförmigen Spule nach außen austretende Hochfrequenz feld abzuschirmen. Auf die Funktion des Probenkopfes und insbesondere die Feldverteilung des Hochfrequenzfeldes innerhalb der Spule hat diese Abschirmung jedoch allenfalls einen nachgeordneten Einfluß. Um nämlich den bekannten Probenkopf in der gewünschten Weise zu betreiben, müssen nicht nur die freiliegenden Innenleiter präzise positioniert werden, auch die Position bzw. die Länge der diese freiliegenden Innenleiter verbindenden Rückflußschleifen müssen exakt so gewählt sein, daß sich eine streng vorgegebene Amplituden- und Phasenverteilung der Ströme auf den freiliegenden Innenleitern ergibt. Aus diesem Grunde ist, elektrisch gesehen, dieser bekannte Probenkopf von der Funktion her eine abgeschirmte Spule mit mehrerern diskreten Einzelwindungen, deren Funktion und Feldverteilung ausschließlich durch die Dimensionierung und die Lage der einzelnen Windungen bestimmt ist.

Ein ähnlicher Probenkopf, wie er vorstehend geschildert wurde, ist noch aus der EP-A-0 047 065 bekannt. Die Koppelanordnung kann bei diesem Probenkopf aus einer im Zwischenraum zwischen den Mänteln angeordneten, in ihrer Orientierung veränderbaren Antenne bestehen.

Aus der EP-A-0 141 383 sind noch zahlreiche weitere Probenköpfe bekannt, bei denen axial verlaufende Leiter, die zueinander parallel gleichförmig auf dem Umfang eines rohrförmigen Tragekörpers verteilt sind, einen zylindrischen Probenraum umgeben, in dem sich eine Probe befindet, an der Kernspinresonanz-Tomographiemessungen durchgeführt werden sollen. Diesen bekannten Probenköpfen ist jedoch sämtlich gemein, daß die axial verlaufenden Leiter in einem stirnseitigen, elektrisch leitenden Ring enden, an den sie entweder unmittelbar galvanisch oder kapazitiv angekoppelt sind. Ein äußerer zylindrischer Mantel fehlt, jedoch ebenso wie sonstige Rückflußmöglichkeiten für den Hochfrequenzstrom. Zur Abstimmung des Probenkopfes ist ein rohrförmiger, elektrisch leitfähiger Abschnitt innerhalb der Leiter axial verschiebbar angeordnet. Der Probenkopf kann mit Beobachtungsöffnungen versehen sein.

Schließlich ist aus der DE-A-31 33 432 noch ein Proben kopf für die Kernspinresonanz-Tomographie bekannt, bei der eine symmetrische Vierdraht-Leitung von einer Stirnseite her paarweise gegenphasig mit einem Hochfrequenzstrom gespeist wird. Die gegenüberliegenden Enden der vier Leitungsstücke sind mit Kondensatoren an einen stirnseitig umlaufenden Ring angeschlossen, von dem bandförmige Längsstäbe zu einem entsprechenden Ring führen, der am entgegengesetzten stirnseitigen Ende angeordnet ist, von dem die Vierdraht-Leitung in der erwähnten Weise gegenphasig gespeist wird.

Dieser bekannte Probenkopf hat damit, elektrisch gesehen, ebenfalls den Aufbau und die Funktion einer elektrischen Spule mit diskret verteilten vier Windungen, so daß es für die exakte Funktion dieses Probenkopfes in besonderem Maße auf die genaue Positionierung der vier Leitungsstücke und auf die genaue Phasenbeziehung beim Speisen dieser Leitungsstücke ankommt.

Der Erfindung liegt demgegenüber die Aufgabe zugrunde, einen Probenkopf der eingangs genannten Art dahingehend weiterzubilden, daß bei möglichst einfachem mechanischem Aufbau, der möglichst keiner Justage bedarf, ein ebenfalls zur Längsachse orthogonales Hochfrequenz-Magnetfeld mit sehr guter Homogenität über den gesamten Probenraum erzielt wird.

Diese Aufgabe wird bei einem gattungsgemäßen probenkopf durch die im kennzeichnenden Teil des Anspruchs 1 angegebenen Merkmale gelöst.

Die zugrundeliegende Aufgabe wird damit vollkommen gelöst, weil auf diese Weise ein völlig anderes Resonanzsystem entsteht, bei dem es nicht auf die diskrete Verteilung einzelner Leiterbahnen, deren relative Lage oder Länge zueinander oder eine spezielle Hochfrequenzspeisung ankommt, sondern vielmehr ein Probenkopftypus entsteht, bei dem der innere zylindrische Mantel in praktisch möglicher Annäherung eine elektrische Leitfähigkeit nur in axialer Richtung aufweist. Dies wird zum einen durch die genannte sehr große Anzahl von Leitern erreicht, zum andern aber auch dadurch, daß die Leiter untereinander keinerlei galvanische Verbindung aufweisen, sondern an beiden Stirnflächen des Probenkopfes ausschließlich über Kondensatoren mit diesen Stirnflächen verbunden sind.

Da es aus diesem Grunde auf die geometrischen Gegebenheiten weniger genau ankommt, treten auch keinerlei Justageprobleme auf, wie sie sich bei den Spulenwindungen oder der Vierdraht-Leitung nach dem Stand der Technik einstellen. Als Rückleitung dienen nach der Erfindung nämlich die Stirnflächen sowie der äußere zylindrische Mantel insgesamt, die auf einfache konstruktive Art starr und raumfest ausgebildet werden können, so daß weder bei der Herstellung noch bei der Benutzung des Probenkopfes irgendwelche Justagen erforderlich sind.

Bei einer bevorzugten Weiterbildung der Erfindung sind, wie an sich aus der EP-A-0 141 383 bekannt, die Leiter als Leiterbahnen einer geätzten Kupferkaschierung auf dem rohrförmigen Tragekörper ausgebildet.

Diese Maßnahme hat den Vorteil einer hohen mechanischen Stabilität.

Bei einer anderen Weiterbildung der Erfindung ist im Zwischenraum zwischen den Mänteln eine um eine zur Achse des hohlzylindrischen Gehäuses parallele Achse drehbare Schleifenantenne angeordnet, deren Fläche parallel zur Achse des hohlzylindrischen Gehäuses liegt.

Diese Maßnahme hat den Vorteil, daß die Hochfrequenz Energie, die zum Anregen der Kernspinresonanz in der Probe erforderlich ist, so eingespeist werden kann, daß gleichzeitig ein Abgleich des probenkopfes je nach den physikalischen Eigenschaften der zu messenden Probe möglich ist.

Bei anderen Weiterbildungen der Erfindung sind, wie an sich aus der EP-A-0 047 065 und der DE-A-31 33 432 bekannt, mindestens zwei um 90° über den Umfang des Probenkopfes verteilte Koppelanordnungen vorgesehen, deren Hochfrequenz-Speiseströme um 90° phasenverschoben sind.

Diese Maßnahme hat den Vorteil, daß im Probenraum eine zirkularpolarisierte Anregung erzeugt werden kann, die insbesondere durch die vorstehend genannte Drehung einer Schleifenantenne um ihre Achse fein justiert werden kann. Bei der Verwendung einer zirkularpolarisierten Anregung ergibt sich jedoch bekanntlich in der Kernspinresonanz eine höhere Signalausbeute bzw. ein besseres Signal/Rauschverhältnis, weil sowohl die Anregungsenergie besser genutzt als auch das Kernspinresonanzsignal besser empfangen werden kann, da beide Vorgänge im "rotierenden System" erfolgen.

Besonders bevorzugt ist bei dieser Weiterbildung eine Variante, bei der die Koppelanordnungen aus einer gemeinsamen Hochfrequenz-Stromquelle gespeist werden, wobei die Versorgungsleitung für eine der Koppelanordnungen um 90° elektrisch länger als die Versorgungsleitung der anderen Koppelanordnung ist.

Diese Maßnahme hat den Vorteil eines besonders einfachen elektrischen Aufbaus, was deswegen möglich ist, weil Probenköpfe der hier interessierenden Art üblicherweise bei einer einzigen festen Frequenz betrieben werden, so daß ein Kabel einer bestimmten Länge eine definierte Phasenverschiebung erzeugt.

Bei weiteren Ausgestaltungen der Erfindung ist mindestens ein rohrförmiger, elektrisch leitfähiger Abschnitt im inneren Mantel axial verschiebbar angeordnet.

Diese Maßnahme hat den Vorteil, daß eine einfache Abstimmung durch Beeinflussung des Randfeldes möglich ist. Dies gilt insbesondere dann, wenn bei einer Variante dieses Ausführungsbeispiels zwei Abschnitte im inneren Mantel im Bereich der Stirnflächen angeordnet sind.

Andere Weiterbildungen der Erfindung zeichnen sich dadurch aus, daß der äußere Mahtel mit Beobachtungsöffnungen versehen ist.

Diese Maßnahme hat den Vorteil, daß die zu messende Probe während der Messung beobachtet werden kann, was insbesondere bei lebenden Meßobjekten wichtig sein kann. Außerdem hat das Vorsehen einer Beobachtungsöffnung auch Vorteile bei Ganzkopfmessungen, weil der Patient, dessen Kopf sich vollständig im Probenkopf befindet, wenigstens etwas nach außen blicken kann und sich deshalb Unruhegefühle beim Patienten weniger einstellen werden.

Besonders bevorzugt ist schließlich eine Weiterbildung der Erfindung, bei dem, wie aus der DE-A-31 33 432 bekannt, der Probenkopf so dimensioniert ist und die Koppelanordnungen so ausgelegt sind, daß sich bei gegebener Frequenz des Hochfrequenz-Speisestromes eine stehende Welle im Probenkopf von weniger als einer halben Wellenlänge ausbildet, derart, daß ein Maximum des magnetischen Hochfrequenz-Feldes sich auf halber axialer Länge des Probenkopfes einstellt.

Diese Maßnahme hat den Vorteil, daß die Probe mit maximalem magnetischen Hochfrequenz-Feld angeregt wird und daher sowohl die Anregung mit geringstmöglicher Hochfrequenzleistung erfolgen kann wie auch die Signalausbeute beim Empfangen des Signales optimiert ist.

Ausführungsbeispiele der Erfindung sind in der Zeichnung dargestellt und werden in der nachfolgenden Beschreibung näher erläutert. Es zeigen:

Fig. 1 eine perspektivische Darstellung eines Probenkopfes, teilweise aufgebrochen;

Fig. 2 eine Schnittdarstellung entlang der Linie II-II von Fig. 1, in vergrößertem Maßstab;

Fig. 3 eine Schnittdarstellung entlang der Linie III-III von Fig. 1, ebenfalls in vergrößertem Maßstab;

Fig. 4 eine Schnittdarstellung zur Erläuterung einer Koppeleinrichtung;

Fig. 5 eine schematische Darstellung der sich einstellenden Verteilung des magnetischen Feldes im Probenkopf;

Fig. 6 eine Darstellung zu Fig. 5, jedoch in axialer Richtung; und

Fig. 7 eine schematische Darstellung zur Erläuterung des elektrischen Anschlusses von Koppelanordnungen bei einem erfindungsgemäßen Probenkopf.

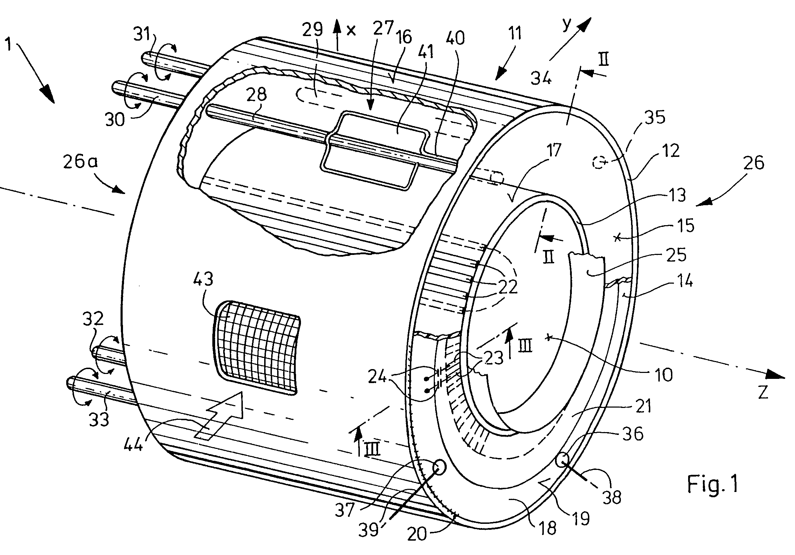

In Fig. 1 bezeichnet 1 insgesamt einen Probenkopf für die Kernspinresonanz-Tomographie oder NMR-Tomographie, wobei die Buchstaben NMR für "Nuclear Magnetic Resonance" stehen. Es versteht sich jedoch, daß der Probenkopf auch für übliche NMR-Messungen an chemischen oder biologischen Substanzen einsetzbar ist.

Die Längsachse des im wesentlichen zylindrischen Probenkopfes 1 ist mit z, und die dazu orthogonalen Achsen sind mit x und y bezeichnet. Es ist bekannt, derartige Probenköpfe 1 für die Kernspinresonanz-Tomographie in einem Magnetfeld hoher Feldstärke und Homogenität anzuordnen, dessen Richtung mit der Achse z des Probenkopfes 1 zusammenfällt.

Eine Probe, insbesondere eine lebende Probe, beispielsweise ein Kopf oder Gliedmaßen eines Menschen oder Tieres, werden in einen Probenraum 10 des Probenkopfes 1 gebracht und dort einem magnetischen Hochfrequenz-Feld ausgesetzt, das im wesentlichen senkrecht zur Achse z des konstanten magnetischen Feldes verläuft. Probenköpfe 1 für die Kernspinresonanz-Tomographie dienen daher generell dazu, ein Hochfrequenz-Magnetfeld auf die Probe einzustrahlen, das senkrecht zur Richtung des Konstant-Magnetfeldes gerichtet und möglichst homogen ist.

Der Probenkopf 1 gemäß Fig. 1 umfaßt ein hohlzylindrisches Gehäuse 11 mit einem äußeren Mantel 12 und einem inneren Mantel 13 sowie geschlossenen Stirnflächen 14, die den Zwischenraum 15 zwischen den Mänteln 12, 13 überbrücken.

Die Oberfläche 16 des äußeren Mantels 12 und die Oberfläche 17 des inneren Mantels 13 sind elektrisch leitend ausgebildet. Die Stirnflächen 14 sind radial unterteilt. Ein äußerer kreisbogenförmiger Bereich 18 verfügt über eine ebenfalls elektrisch leitfähige Oberfläche 19, die mit einer umlaufenden Lötstelle 20 mit der leitenden Oberfläche 16 des äußeren Mantels 12 verbunden ist. Ein innerer Bereich 21 der Stirnflächen 14 ist hingegen nichtleitend.

Die leitende Oberfläche 17 des inneren Mantels 13 ist nur in einer Richtung parallel zur Achse z des Gehäuses 11 elektrisch leitend, weil sie in axiale Leiter 22 unterteilt ist. Jeder der Leiter 22 ist mit einem radial verlaufenden leitfähigen Streifen 23 auf dem inneren Bereich 21 der Stirnflächen 14 verbunden. Von den Streifen 23 führen Kondensatoren 24 zum äußeren, leitfähigen Bereich 18 der Stirnfläche 14.

Die Anzahl der Leiter ist von den Dimensionen des Probenkopfes abhängig. Bei kleineren Abmessungen sind — auch aus praktischen Gründen — weniger Leiter, beispielsweise nur 10 oder 20 Leiter bei einem Innendurchmesser von 10 mm ausreichend. Bevorzugt sind mehr als zehn Leiter vorgesehen, wobei eine Zahl von mehr als fünfzig Leitern als vorteilhaft angesehen wird. Bei größeren Durchmessern kann die Anzahl der Leiter sogar einige hundert betragen.

Wesentlich ist, daß eine nur axiale Leitfähigkeit bestmöglich angenähert wird, damit die Nachteile bekannter Probenköpfe vermieden werden, die diskret verteilte Leiter als Elemente einer Spule berücksichtigen müssen.

Im Bereich der Stirnfläche 14 ist in den inneren Mantel 13 ein rohrförmiger, ebenfalls elektrisch leitender Abschnitt 25 eingeschoben, der in Richtung der Achse z verschiebbar ausgebildet ist.

Die vorstehende Schilderung bezieht sich auf nur eine Stirnseite 26 des Probenkopfes 1, es versteht sich jedoch, daß auch die gegenüberliegende Stirnseite 26a, die in Fig. 1 nicht im einzelnen dargestellt ist, in entsprechender Weise ausgebildet ist, so daß der Probenkopf 1 insgesamt symmetrisch aufgebaut ist.

Um elektrische Energie in den Probenkopf 1 einzukoppeln, sind vier über den Umfang verteilte Koppelanordnungen vorgesehen, von denen nur eine mit 27 im einzelnen dargestellt ist. Zum Justieren der Koppelanordnungen 27 sind Stangen 28, 29 vorgesehen, die den Zwischenraum 15 parallel zur Achse z durchsetzen. An einem Ende laufen die Stangen 28, 29 in Griffe 30, 31, 32, 33 aus, die in Richtung der eingezeichneten Doppelpfeile verdrehbar sind. Die entgegengesetzten Enden der Stangen 28, 29 ruhen in Lagern 34, 35, 36, 37 der gegenüberliegenden Stirnfläche 14, wobei die Lager 34, 35, 36, 37 gleichzeitig als Anschlüsse dienen, wie bei 38 und 39 angedeutet.

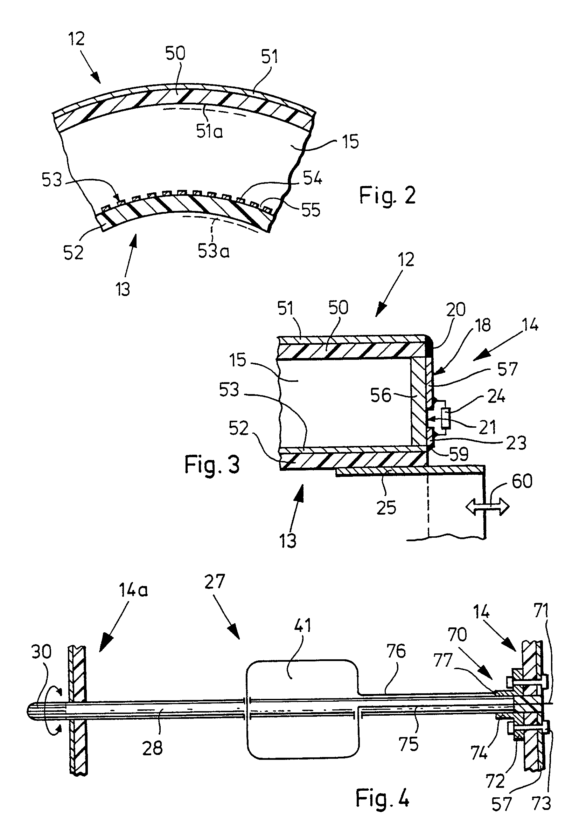

Von den Anschlüssen 38, 39 führt eine axiale Leitung 40 zu einer im wesentlichen in der axialen Mitte der Stangen 28, 29 angeordneten Schleifenantenne 41, deren Einzelheiten weiter unten zu Fig. 4 noch erläutert werden.

Schließlich ist im äußeren Mantel 12 noch eine Beobachtungsöffnung 43 vorgesehen, durch die ein Blick in das Innere des Probenkopfes und auch in den Probenraum 10 in Richtung eines Pfeiles 44 möglich ist.

In Fig. 2 sind die Einzelheiten der Mäntel, 12, 13 dargestellt.

Der Mantel 12 besteht aus einem Tragekörper 50 und einer Kupferkaschierung 51. Der Tragekörper 50 kann aus Glas, Keramik oder Kunststoff bestehen. Als besonders geeignet hat sich ein glasfaserverstärkter Kunststoff erwiesen, der eine Dielektrizitätszahl ε von 3,8 und einen Verlustfaktor tan δ von 0,15 bei 50 Hz aufweist.

Statt der Kupferkaschierung 51 kann selbstverständlich auch jede andere leitfähige Oberfläche verwendet werden, beispielsweise eine Bedampfung, ein Leitlack o. ä. Auch kann die Kupferkaschierung 51 oder die andere leitfähige Oberfläche ebenso an der Innenseite des Tragekörpers 50 angebracht sein, wie mit 51a angedeutet.

Der innere Mantel 13 besteht ebenfalls aus einem Tragekörper 52 und einer Kupferkaschierung 53, die gleichfalls an der Innenseite bei 53a angeordnet sein kann. Durch Ätzen oder eine andere an sich bekannte Technik werden Leiterbahnen 54 mit dazwischenliegenden Zwischenräumen 55 in die Kupferkaschierung 53 eingebracht. Als Material für den Tragekörper 52 des inneren Mantels 13 kann ebenfalls Glas, Keramik oder Kunststoff verwendet werden, als besonders geeignet hat sich ein Polyvinylchlorid (PVC) erwiesen, der eine Dielektrizitätszahl ε von 3,5 und einen Verlustfaktor tan δ von 0,03 bei 1 MHz aufweist.

Bei der Darstellung gemäß Fig. 3 sind die Verhältnisse im Bereich der Stirnflächen 14 im einzelnen dargestellt. Die Stirnflächen 14 bestehen aus einem Tragekörper 56 und einer Kupferkaschierung 57 im äußeren Bereich 18. Das aus äußerem Bereich 18, innerem Bereich 21 und Streifen 23 bestehende Muster kann durch Ätzen u. dgl. der Kupferkaschierung 57 erzeugt werden. Eine umlaufende Lötstelle 20 stellt die Verbindung zwischen dem äußeren Bereich 18 und der Kupferkaschierung 51 her. Mit einer Lötstelle 59 sind die Streifen 23 an die Kupferkaschierung 53 des inneren Mantels 13 angeschlossen. Als Material für den Tragekörper 56 kann wiederum Glas, Keramik oder Kunststoff verwendet werden, als besonders geeignet hat sich das bereits für den Tragekörper 52 erwähnte Polyvinylchlorid erwiesen.

Bei einem praktischen Ausführungsbeispiel des erfindungsgemäßen Probenkopfes 10 besteht die Kupferkaschierung 51 des äußeren Mantels 12 aus einem Kupferblech von 0,3 mm Dicke, das auf die Außenseite des Tragekörpers 50 aufgewickelt und entlang einer Mantellinie verlötet ist. Als Kupferkaschierung 53 des inneren Mantels 13 wird bei einem praktischen Ausführungsbeispiel ein flexibles Leiterplatten material verwendet, dessen leitfähige Oberfläche aus einer Kupferschicht von 35 um Dicke besteht. Auf diese Weise wird ein Probenkopf von 250 mm Länge, einem Außendurchmesser von ca. 250 mm und einem Innendurchmesser von ca. 160 mm aufgebaut. Es sind 120 äquidistante Leiter 22 auf den inneren Mantel 13 aufgebracht und jeweils mit einem Kondensator von 2,7 pF an beiden Seiten der Stirnflächen angeschlossen, wobei der Probenkopf für eine Meßfrequenz von 100 MHz ausgelegt ist. Zur Abstimmung des Probenkopfes 10 gemäß Fig. 1 bis 3 dient zum einen der axial in Richtung eines Pfeiles 60 in Fig. 3 verschiebbare rohrförmige Abschnitt 25, der an jeder Stirnfläche eine einstellbare Kapazität von ca. 100 pF bildet, wobei der Tragkörper 52 als Dielektrikum dient. Die Kupferkaschierung 53 ist in diesem Falle die Gegenelektrode. Zur weiteren Abstimmung bei der Ankopplung dient die bereits zu Fig. 1 erwähnte Schleifenantenne 41, wie sie im einzelnen in Fig. 4 dargestellt ist.

In die Stirnfläche 14 ist eine Koaxialbuchse 70 eingesetzt, deren innerer Anschlußleiter 71 nach außen weist. Das auf Masse liegende Gehäuse 72 der Koaxialbuchse 70 ist mit Schrauben 73 leitend mit der Kupferkaschierung 57 verbunden. In ein zylindrisches Steckteil 74 der Koaxialbuchse 70 ist die Stange 28 eingesteckt, so daß sie in Richtung des Doppelpfeiles am Griff 30 verdreht werden kann. Mit dem Anschlußleiter 71 ist ein Innenleiter 75 verbunden, der axial durch die Stange 28 führt und im wesentlichen in der axialen Mitte der Stange 28 zu der Schleifenantenne 41 umgebogen ist. Von der Schleifenantenne 41 führt dann ein Außenleiter 76 zu einer Lötstelle 77 am mit Masse verbundenen Steckteil 74.

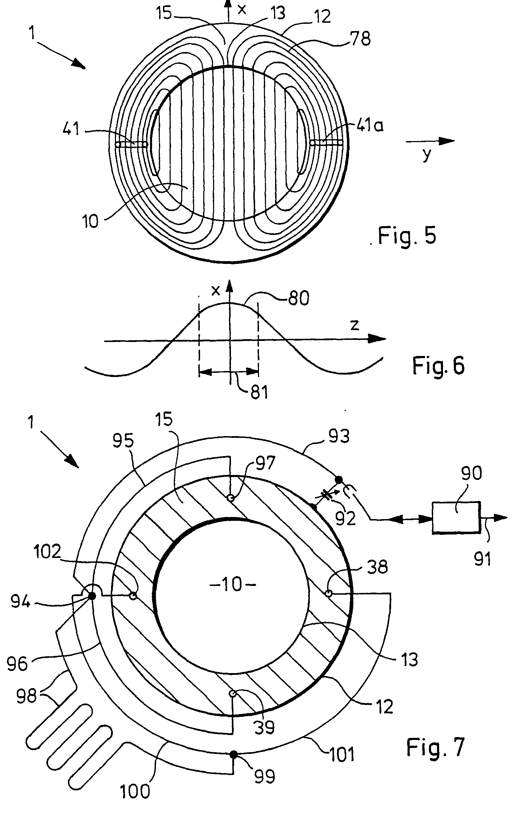

Wie Fig. 5 im radialen Schnitt durch den Probenkopf 1 deutlich zeigt, ergibt sich bei einer Stellung der Schleifenantenne 41 in radialer Richtung ihrer Fläche eine Ankopplung, bei der sich eine Feldverteilung des magnetischen Feldes 78 einer TEM-Dipolwelle einstellt, die im Probenraum 10 in hohem Maße senkrecht zur Längsachse verläuft und gleichzeitig sehr homogen ist. Im Zwischenraum 15 schließen sich die Linien des magnetischen Feldes 78, wobei sie im wesentlichen in Umfangsrichtung verlaufen. Sie durchsetzen damit die Schleifenantenne 41 praktisch senkrecht, wobei geringfügige Störungen durch Drehen der Schleifenantenne 41 kompensiert werden können. Besonders effektiv läßt sich das magnetische Feld gemäß Fig. 5 dann anregen, wenn um 180° gegeneinander versetzt zwei Schleifenantennen 41 41a angeordnet sind, die gleichphasig mit Hochfrequenz-Strom gespeist werden.

In axialer Richtung betrachtet verläuft die Amplitude des magnetischen Feldes mit einer Charakteristik wie sie Fig. 6 zeigt. Man erkennt, daß ein "Feldbauch" 80 in der Mittelebene des Probenkopfes 1 auftritt, wobei die Dimensionierung, die Ankopplung und insbesondere der elektrische Anschluß an den Stirnflächen 14 des Probenkopfes 1 so gewählt ist, daß aus dem axialen Verlauf gemäß Fig. 6 nur ein Abschnitt 81 von maximaler Amplitude des magnetischen Feldes erfaßt wird.

Fig. 7 zeigt schließlich eine Variante, bei der, wie bereits zu Fig. 1 angedeutet, vier Koppelanordnungen um jeweils 90° gegeneinander versetzt über einen Umfang im Zwischenraum 15 des Probenkopfes 1 angeordnet sind. Ein Sender/Empfänger 90 dient zum Einspeisen von Hochfrequenz-Strom in den Probenkopf 1 und zum Empfangen von Kernresonanzsignalen. Zur Weiterverarbeitung dieser Signale ist der Sender/Empfänger 90 mit einem an sich bekannten Tomographen verbunden, wie mit einem Pfeil 91 angedeutet. Der Sender/Empfänger 90 arbeitet auf ein aus einer ersten Leitung 93 und einem einstellbaren Kondensator 92 gebildetes Ankopplungsnetzwerk, mit dem beispielsweise ein Innenwiderstand von 50 Ohm des Probenkopfes 1 eingestellt werden kann, so daß der Probenkopf 1 optimal an einen üblichen Sender/Empfänger 90 angepaßt ist. Die erste Leitung 93 führt zu einem ersten Knotenpunkt 94, von dem symmetrisch eine zweite Leitung 95 und eine dritte Leitung 96 jeweils gleicher Länge ausgehen. Die Leitungen 95, 96 führen zu einem Anschluß 97 bzw. dem bereits zu Fig. 1 erläuterten Anschluß 39. Die Anschlüsse 97 und 39 werden daher mit gleicher Phase angesteuert, wie bereits zu den Koppelanordnungen 41, 41a in Fig. 5 erläutert. Weiterhin führt vom ersten Knotenpunkt 94 eine vierte Leitung 98 weg, deren Länge so bemessen ist, daß sie für die Betriebsfrequenz des Probenkopfes 1 gerade eine Phasenver schiebung von 90° ergibt.

Mit anderen Worten ist die Versorgungsleitung 93, 95 für eine der Koppelanordnungen 27 elektrisch so ausgebildet, daß sich eine phasenverschiebung von 90° bezüglich der Versorgungsleitung der anderen Koppelanordnung 27 ergibt.

Die vierte Leitung 98 führt zu einem zweiten Knotenpunkt 99, von dem, wiederum symmetrisch, eine fünfte Leitung 100 und eine sechste Leitung l01 ausgehen. Die Leitungen 100, 101 führen zu einem Anschluß 102 sowie zu einem diametral gegenüberliegenden Anschluß 38, der bereits zu Fig. 1 erwähnt wurde. Auf diese Weise werden die Anschlüsse 97 und 39 gleichphasig und die Anschlüsse 102, 38 ebenfalls gleichphasig, jedoch gegenüber den Anschlüssen 97, 39 um 90° phasenversetzt angesteuert. Im Probenraum 10 ergibt sich somit eine Überlagerung zweier linear polarisierter, jedoch räumlich und elektrisch um 90° versetzter Wellen, was bekanntlich eine zirkulare Polarisation ergibt.

**Patentansprüche**

1. Probenkopf für Kernresonanz-(NMR)-Messungen, insbesondere für die Kernspinresonanz-Tomographie, mit einem hohlzylindrischen Gehäuse (11), das einen äußeren zylindrischen starren Mantel (12), der im wesentlichen durchgehend aus elektrisch leitendem Material besteht, einen inneren, zylindrischen, einen Probenraum (10) umgebenden Mantel (13), der mit einer Mehrzahl von auf dem Umfang eines rohrförmigen Tragekörpers (52) aus dielektrischem Material gleichmäßig verteilt angeordneten, zueinander parallelen und axial verlaufenden, räumlich festliegenden elektrischen Leitern (22) versehen ist und zwischen den Mänteln (12, 13) angeordnete starre, wechselstromdurchlässige, elektrisch leitendes Material aufweisende Stirnflächen (14), die mit dem äußeren Mantel (12) elektrisch leitend und starr verbunden sind, aufweist, und mit einer zwischen dem äußeren und inneren Mantel angeordneten Koppelanordnung (27) zum Erzeugen elektrischer hochfrequenter Ströme in den Leitern (22), dadurch gekennzeichnet, daß die Leiter (22) jeweils an ihren beiden Enden ausschließlich über Kondensatoren (24) mit den beiden Stirnflächen (14) elektrisch verbunden sind, daß die Stirnflächen (14) und der äußere Mantel (12) die Rückleitung für die Leite 22) sind, und daß mindestens zehn Leiter (22) gleichmäßig über den inneren Mantel (13) verteilt angeordnet sind.

2. Probenkopf nach Anspruch 1, dadurch gekennzeichnet, daß die Leiter (22) als Leiterbahnen (54) einer geätzten Kupferkaschierung (53) des rohrförmigen Trägerkörpers (52) ausgebildet sind.

3. Probenkopf nach Anspruch 2, dadurch gekennzeichnet, daß der innere Mantel (13) mindestens 120 Leiter (22) aufweist.

4. Probenkopf nach einem der vorhergehenden Ansprüche, dadurch gekennzeichnet, daß die Stirnflächen (14) in einem inneren Bereich (21) radial verlaufende, leitfähige Streifen (23) und einen äußeren, leitfähigen Bereich (18) aufweisen, und daß jeder Leiter (22) mit einem der Streifen (23) verbunden ist, von dem einer der Kondensatoren (24) zum äußeren Bereich führt.

5. Probenkopf nach einem der Ansprüche 1 bis 4, dadurch gekennzeichnet, daß die Koppelanordnung (27) aus einer im Zwischenraum (15) zwischen den Mänteln (12, 13) angeordneten, um eine zur Zylinderachse (z) des Gehäuses (11) parallele Achse drehbaren Schleifenantenne (41) besteht, deren Fläche parallel zur Zylinderachse (z) des Gehäuses (11) liegt.

6. Probenkopf nach einem der Ansprüche 1 bis 5, dadurch gekennzeichnet, daß mindestens zwei um 90° über den Umfang des Probenkopfes (1) verteilte Koppelanordnungen (27) vorgesehen sind, deren Hochfrequenz-Speiseströme um 90° phasenverschoben sind.,

7. Probenkopf nach Anspruch 6, dadurch gekennzeichnet, daß die Koppelanordnungen (27) über Versorgungsleitungen (93) aus einer gemeinsamen Hochfrequenz-Stromquelle (90) gespeist sind, wobei die Versorgungsleitung (93, 95) für eine der Koppelanordnungen (27) elektrisch so ausgebildet ist, daß sie eine phasenverschiebung um 90° bezüglich der Versorgungsleitung (93, 98, 100) der anderen Koppelanordnung (27) aufweist.

8. Probenkopf nach einem der Ansprüche 1 bis 7, dadurch gekennzeichnet, daß mindestens ein rohrförmiger elektrisch leitfähiger Abschnitt (25) innerhalb des inneren Mantels (13) axial verschiebbar angeordnet ist.

9. Probenkopf nach Anspruch 8, dadurch gekennzeichnet, daß zwei Abschnitte (25) innerhalb des inneren Mantels (13) im Bereich der Stirnflächen (14) angeordnet sind.

10. Probenkopf nach einem der Ansprüche 1 bis 9, dadurch gekennzeichnet, daß der äußere Mantel (12) mit Beobachtungsöffnungen (43) versehen ist.

11. Probenkopf, nach einem der Ansprüche 1 bis 10, dadurch gekennzeichnet daß er so dimensioniert ist und bei ihm die Koppelanordnungen (27) so ausgelegt sind, daß sich bei gegebener Frequenz des Hochfrequenz-Speisestromes eine stehende Welle im Probenkopf ausbildet, und daß die stehende Welle weniger als eine halbe Wellenlänge aufweist, derart, daß ein Maximum des magnetischen Hochfrequenz-Feldes sich auf halber axialer Länge des Probenkopfes (1) einstellt.

## Revendications

1. Tête de sonde pour mesures en résonance magnétique nucléaire, en particulier pour la tomographie, utilisant la résonance de spin du noyau, formée d'un boîtier (11) cylindrique creux à chemise extérieure cylindrique rigide (12) réalisé essentiellement en matière perméable et électriquement conductrice et comprenant une chemise enveloppante (13) intérieure et cylindrique entourant une chambre de sonde (10) compartimentée de façon égale sur toute la périphérie d'un support tubulaire (52) en matériau diélectrique par un réseau d'une pluralité de barres conductrices (22) axiales, parallèles entre elles et fixées à demeure, et entre les chemises (12, 13) étant prévues des surfaces frontales ou flasques (14) en matériau rigide, perméable au courant alternatif et électriquement conducteur reliés rigidement et électriquement à la chemise extérieure (12), comprenant en outre un ensemble de couplage (27) entre les chemises intérieure et extérieure, de façon à générer un courant de haute fréquence dans le réseau de barres conductrices, caractérisé en ce que chaque barre conductrice (22) du réseau de barres conductrices est reliée électriquement et exclusivement à chacune de ses deux extrémités aux deux flasques (14) par des condensateurs (24) et en ce que les flasques (14) et la chemise extérieure (12) constituent le circuit électrique de retour pour les barres (22) et en ce qu'au moins dix barres (22) de même dimension sont disposées au-dessus de la chemise cylindrique intérieure (13).

2. Tête de sonde selon la revendication 1, caractérisée en ce que les barres (22) sont réalisées sous la forme d'un capot de cuivre du support tubulaire (52) corrodé selon une échelle de rails (54).

3. Tête de sonde selon la revendication 2, caractérisée en ce que la chemise intérieure (13) comporte au moins cent vingt barres conductrices (22).

4. Tête de sonde selon l'une des revendications précédentes, caractérisée en ce que le flasque (14) présente d'une part sur une zone intérieure (21) des bandes conductrices (23) s'étendant radialement et, d'autre part, une zone extérieure conductrice (18) et en ce que chaque barre (22) est reliée à l'une des bandes (23) et rappelée électriquement à travers l'un des condensateurs (24) à la zone extérieure.

5. Tête de sonde selon l'une des revendications de 1 à 4, caractérisée en ce que l'ensemble de couplage (27) se compose d'une chambre intermédiaire (15) entre les chemises (12, 13) pour former une antenne à boucle rotative parallèle à l'axe (z) du cylindre du boîtier (11) dont la surface est parallèle à l'axe (z) du cylindre du boîtier (11).

6. Tête de sonde selon l'une des revendications de 1 à 5, caractérisée en ce qu'elle comporte au moins deux ensembles de couplage (27) dissociés, couvrant chacun au moins 90° d'angle autour de la tête de sonde.

7. Tête de sonde selon la revendication 6, caractérisée en ce que l'ensemble de couplage (27) est alimenté par une source haute fréquence commune (90) à travers une ligne d'alimentation respectivement (93, 95), les lignes d'alimentation (93, 95) étant conformées électriquement pour que l'un des ensembles de couplage (27) permette un décalage de phase de 90° entre les lignes d'alimentation (93, 95 et 100) de l'autre ensemble de couplage (27).

8. Tête de sonde selon l'une des revendications de 1 à 7, caractérisée en ce qu'au moins une section tubulaire (25) électriquement conductrice est prévue déplaçable par coulissement axial à travers la chemise intérieure (13).

9. Tête de sonde selon la revendication 8, caractérisée en ce que deux sections (25) sont prévues à l'intérieur de la chemise intérieure (13) dans la zone des flasques (14).

10. Tête de sonde selon les revendications de 1 à 9 caractérisée en ce que la chemise extérieure (12) est pourvue d'ouvertures d'observation (43).

11. Tête de sonde selon l'une des revendications de 1 à 10, caractérisée en ce qu'elle est de dimensions telles et que l'ensemble de couplage (27) y est incorporé de façon telle qu'à une fréquence donnée de la source de haute fréquence, il se forme une onde stationnaire dans la tête de sonde et en ce que l'onde stationnaire est plus petite qu'une demi-longueur d'onde, de façon que le maximum du champ magnétique haute fréquence s'établisse à mi-longueur axiale de la tête de sonde.

## Claims

1. A probe head for nuclear magnetic resonance (NMR) measurements, in particular for nuclear magnetic resonance tomography, comprising a hollow cylindrical housing (11) having an outer cylindrical rigid wall (12) which comprises electrically conductive material substantially throughout, an inner cylindrical wall (13) which surrounds a sample space (10) and which is provided with a plurality of mutually parallel, axially extending electrical conductors (22) which are fixed in relation to space and which are arranged in a uniformly distributed array on the periphery of a tubular support body (52) of dielectric material, and rigid end faces (14) which are arranged between the walls (12, 13) and which are capable of transmitting alternating current and which have electrically conductive material and which are electrically conductively and rigidly connected to the outer wall (12), and further comprising a coupling means (27) arranged between the inner and outer walls for producing electrical high-frequency currents in the conductors (22), characterised in that the conductors (22) are electrically connected at respective ones of their two ends to the two end faces (14) exclusively by way of capacitors (24), that the end faces (14) and the outer wall (12) are the return for the conductors (22) and that at least ten conductors (22) are arranged in a uniformly distributed array over the inner wall (13).

2. A probe head according to claim 1 characterised in that the conductors (22) are in the form of conductor paths (54) of an etched copper lining (53) on the tubular support body (52).

3. A probe head according to claim 2 characterised in that the inner wall (13) has at least 120 conductors (22).

4. A probe head according to one of the preceding claims characterised in that the end faces (14) have radially extending conductive strips (23) in an inner region and an outer conductive region (18) and that each conductor (22) is connected to one of the strips (23), from which one of the capacitors (24) leads to the outer region.

5. A probe head according to one of claim 1 to 4 characterised in that the coupling means (27) comprises a loop antenna (41) which is arranged in the space (15) between the walls (12, 13) and which is rotatable about an axis parallel to the axis (z) of the cylinder configuration of the housing (11), the surface of the loop antenna being disposed parallel to the axis (z) of the cylinder configuration of the housing (11).

6. A probe head according to one of claims 1 to 5 characterised in that there are at least two coupling means (27) which are distributed through 90° over the periphery of the probe head (1), the high frequency supply currents of the coupling means being phase-shifted though 90°.

7. A probe head according to claim 6 characterised in that the coupling means (27) are supplied from a common high frequency current source (90) by way of supply lines (93), wherein the supply line (93, 95) for one of the coupling means (27) is electrically such that it has a phase shift though 90° with respect to the supply line (93, 98, 100) of the other coupling means (27).

8. A probe head according to one of claims 1 to 7 characterised in that at least one tubular, electrically conductive section (25) is arranged to slide axially within the inner wall (13).

9. A probe head according to claim 8 characterised in that two sections (25) are arranged within the inner wall (13) in the region of the end faces (14).

10. A probe head according to one of claims 1 to 9 characterised in that the outer wall (12) is provided with observation openings (43).

11. A probe head according to one of claims 1 to 10 characterised in that it is so dimensioned and therein the coupling means (27) are so designed that at a given frequency of the high frequency supply current a standing wave is formed in the probe head and that the standing wave is of less than half a wave length in such a way that a maximum of the magnetic high-frequency field occurs at half the axial length of the probe head (1).

Fig.1

EP 0 206 057 B1

Fig. 2

Fig. 3

Fig. 4

Fig. 5

Fig. 6

Fig. 7